# EUROPEAN PATENT APPLICATION

(11) **EP 2 818 414 A2**
(43) Date of publication of application: **31.12.2014**
(21) Application number: 14170884.2
(22) Date of filing: 03.06.2014
(51) Int. Cl.: B64D 41/00, H01L 35/00, H01L 37/02

(54) **Energy recovery and regeneration system**

(30) Priority: 06.06.2013 US 201313911687
(71) Applicant: Hamilton Sundstrand Corporation, Windsor Locks, CT 06096-1010 (US)
(72) Inventor: Ribarov, Lubomir A., West Hartford, CT Connecticut 06107 (US)
(74) Representative: Gittins, Alex Michael

(57) **Abstract**

In at least one embodiment, an energy recovery and regeneration system includes at least one pyroelectric energy recovery module (ERM) (126), a coolant line (128), a valve (130) and an energy storage module (132). The at least one pyroelectric ERM (126) generates a voltage in response to realizing a temperature change. The coolant line (128) includes a first end in fluid communication with a coolant source to receive a coolant and a second end disposed adjacent the at least one pyroelectric ERM (126) to deliver the coolant thereto. The valve (130) is interposed between the coolant source and the at least one pyroelectric ERM (126). The valve (138) modulates the coolant delivered to the at least one pyroelectric ERM (126) to generate the temperate change. The energy storage module (132) is in electrical communication with the pyroelectric ERM (126) to store the voltage generated by the at least one pyroelectric ERM (126).

## Description

### BACKGROUND OF THE INVENTION

Advanced aircraft power generation applications require uninterrupted, reliable electric power availability during the full flight envelope to drive various electrical systems of the aircraft. Conventionally, the aircraft utilizes an electric power generator coupled to the main engines of the aircraft and an auxiliary power unit (APU) to generate the electrical power. These conventional power generation methods, however, include numerous large and complex rotational parts that increase the weight of the aircraft and may induce electrical noise, such as electromagnetic magnetic interference (EMI). As aircraft electrical systems become more complex and provide more electrical features, the demand for lightweight compact energy systems to generate additional power increases.

### BRIEF DESCRIPTION OF THE INVENTION

In at least one embodiment, an energy recovery and regeneration system comprises at least one pyroelectric energy recovery module (ERM), a coolant line, a valve and an energy storage module. The at least one pyroelectric ERM generates a voltage in response to realizing a temperature change. The coolant line includes a first end in fluid communication with a coolant source to receive a coolant and a second end disposed adjacent the at least one pyroelectric ERM to deliver the coolant thereto. The valve is interposed between the coolant source and the at least one pyroelectric ERM. The valve modulates the coolant delivered to the at least one pyroelectric ERM to generate the temperate change. The energy storage module is in electrical communication with the pyroelectric ERM to store the voltage generated by the at least one pyroelectric ERM.

In another embodiment, an energy recovery and regeneration system comprises at least one thermoelectric ERM that includes a first surface and a second surface. The thermoelectric ERM is configured to generate a voltage in response to realizing a temperature differential between the first surface and the second surface. The energy recovery and regeneration system further comprises at least one coolant line including a first end and a second end. The first end is in fluid communication with a coolant source to receive a coolant. The second end is disposed adjacent the second surface of the at least one thermoelectric ERM to deliver the coolant thereto such that the second surface has a temperature less than the first surface. An electronic device is in electrical communication with the at least one thermoelectric ERM, and operates in response to the voltage generated by the thermoelectric ERM.

In still another embodiment, an energy recovery and regeneration system comprises at least one piezoelectric ERM configured to generate a voltage in response to realizing a physical force. At least one coupling member includes a first linking end and a second linking end to deliver the physical force to the at least one piezoelectric ERM. The first linking end is formed at the at least one coupling member and the second linking end is formed against a vibration source. An energy storage module is in electrical communication with the piezoelectric ERM to store the voltage generated by the at least one piezoelectric ERM.

### BRIEF DESCRIPTION OF THE DRAWINGS

The following descriptions should not be considered limiting in any way. With reference to the accompanying drawings, like elements are numbered alike:
FIG. 1A is a top view of a rear portion of an aircraft bulkhead including a pyroelectric energy recovery and regeneration system according to at least one embodiment;
FIG. 1B is a cross-sectional side view taken along line CL-CL of the aircraft rear bulkhead illustrated in FIG. 1A;
FIG. 2 is a top view of a rear portion of an aircraft bulkhead including a pyroelectric energy recovery and regeneration system according to another embodiment;
FIG. 3 is an electrical schematic of a pyroelectric ERM circuit according to an embodiment;
FIGS. 4A-4B illustrate operation of a pyroelectric ERM included in a pyroelectric energy recovery and regeneration system according to an embodiment;
FIG. 5 a top view of a rear portion of an aircraft rear bulkhead including a thermoelectric energy recovery and regeneration system according to another embodiment;
FIG. 6 is an electrical schematic of a thermoelectric ERM circuit according to an embodiment;
FIG. 7 illustrates a thermoelectric ERM included in a thermoelectric energy recovery and regeneration system according to an embodiment;
FIG. 8 is a top view of a rear portion of an aircraft rear bulkhead including a piezoelectric energy recovery and regeneration system according to still another embodiment;
FIG. 9 is an electrical schematic of a piezoelectric ERM circuit according to an embodiment; and
FIGS. 10A-10C illustrate operation of a piezoelectric ERM included in a piezoelectric energy recovery and regeneration system according to an embodiment.

### DETAILED DESCRIPTION OF THE INVENTION

A detailed description of one or more embodiments of the disclosed apparatus and method are presented herein by way of exemplification and not limitation with reference to the Figures.

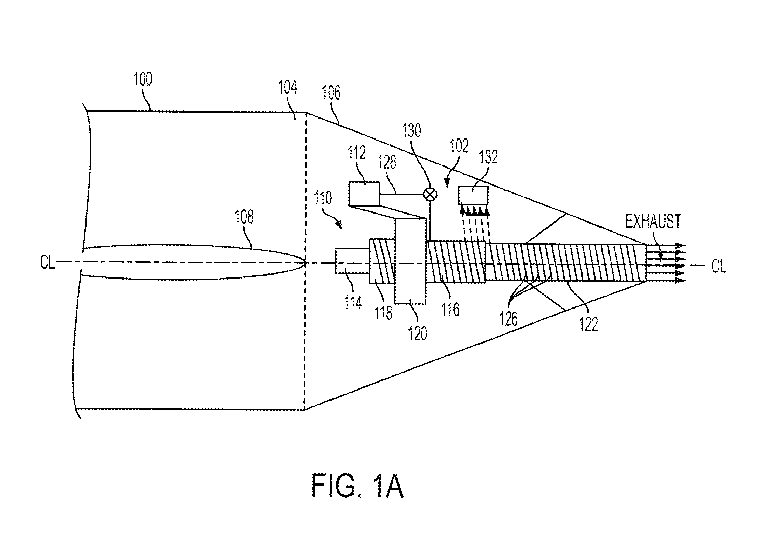

Referring to FIGS. 1A-1B, a rear portion of an aircraft bulkhead 100 (i.e., a rear bulkhead 100) including an energy recovery and regeneration system 102 is illustrated according to at least one embodiment. The rear bulkhead 100 includes fuselage 104 and a tail cone 106. A tail fin assembly 108 may be coupled to an outer surface of the fuselage 104. The tail cone 106 may contain an auxiliary power unit (APU) 110. The APU 110 may include an APU air inlet 112, an APU generator 114, an APU turbine 116, an APU gearbox 118, an APU compressor 120, and an APU exhaust duct 122. The APU turbine 116 operates to drive the APU generator 114 via a drive shaft through the APU gearbox 118. The APU compressor 120 receives ambient inlet air through the APU inlet 112 and delivers compressed air to the APU's combustor where fuel is injected. After combustion is complete, the hot exhaust gases drive the APU's turbine 116 which extracts thermal energy via an open Brayton cycle while rejecting heat and exhaust gases through the APU exhaust duct 122. The air compression in the APU compressor 120 results in the compressed inlet air being heated as well. The APU gearbox 118 is interposed between the APU generator 114 and the APU compressor 120. The APU gearbox 118 may include a clutch that selectively disengages the APU generator 114 from the compressor 120 shaft, thereby controlling power provided to the APU generator 114. Often the APU generator 114 is designed as a hybrid starter/generator (S/G) unit acting as a starter when energized by electric current to start the APU 110 by rotating its input/output shaft and the APU compressor 120. After the APU engine starts and is operating steadily, the S/G unit "reverses" its functionality now operating as a generator producing electric power by being turned by the APU engine's output shaft.

The APU 110 may provide power to start the main turbine engines of the aircraft. For example, the main turbine engines must be accelerated to a high rotational speed in order to provide sufficient air compression for self-sustaining operation. The APU 110 may be used to provide electrical power to one or more accessory systems, such as electronic dashboard electronics, cabin air fans, cabin lighting, lavatory/galley power, etc., while the main engines are shut down. The APU 110 may also be connected to a hydraulic pump, allowing crews to operate hydraulic equipment (such as flight controls or flaps) prior to the main engine(s) start. As previously mentioned, however, the APU 110 requires a variety of moveable and rotational parts.

In at least one embodiment, the aircraft's rear bulkhead 100 contains an energy recovery and regeneration system 102 configured to harness/recover energy existing in the aircraft. The recovered energy may be stored and/or supplied to various electrical sub-systems to increase the energy efficiency of the aircraft. Although at least one embodiment described going forward illustrates the energy recovery and regeneration system 102 contained in the rear bulkhead 100, the location of the energy recovery and regeneration system 102 is not limited thereto. Accordingly, it is appreciated that the energy recovery and regeneration system 102 may be formed at one or more alternative locations of the aircraft.

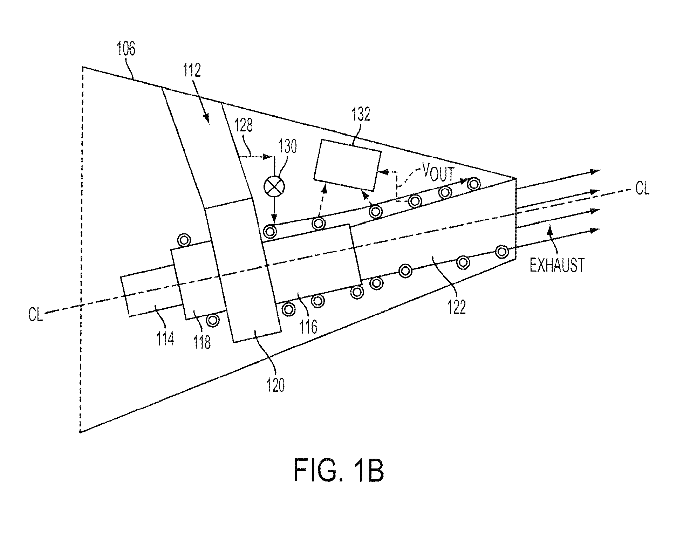

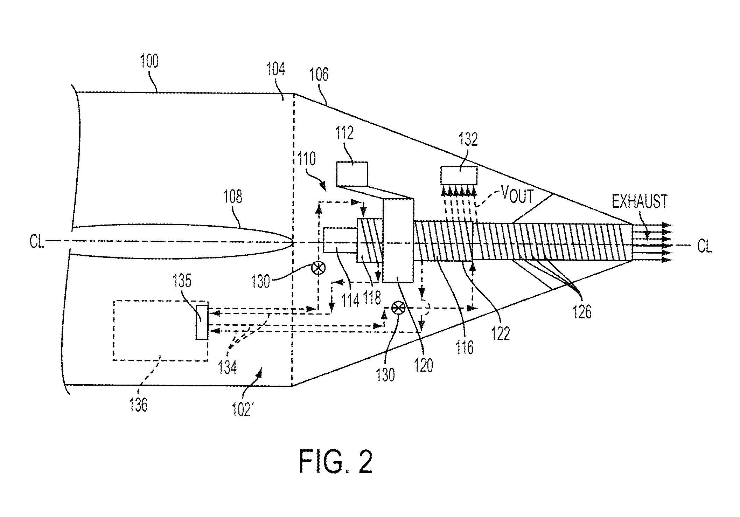

Referring again to FIGS. 1A-1B, the rear bulkhead 100 includes an energy recovery and regeneration system 102 according to an embodiment that is implemented as a pyroelectric energy recovery and regeneration system and will be referred to herein as such. Although a pyroelectric energy recovery and regeneration system 102 is illustrated in FIGS. 1 and 2, other energy recovery and regeneration systems may be implemented including, but not limited to, a thermoelectric energy recovery and regeneration system 102' and a piezoelectric energy recovery and regeneration system 102" as discussed in greater detail below.

The pyroelectric energy recovery and regeneration system 102 includes one or more pyroelectric energy recovery modules (ERMs) 126, a coolant line 128, a fast-acting valve 130, and an energy storage module 132. The pyroelectric ERMs 126 generate a temporary voltage when realizing a temperature change (i.e., when being heated or cooled), as discussed in greater detail below. The pyroelectric ERMs 126 may be disposed against the heated external surface of the APU exhaust duct 122, for example. According to the embodiment illustrated in FIGS. 1A-1B, the coolant line 128 is formed as a bleed air line 128 that is in fluid communication with the APU air inlet 112. The bleed air line 128 diverts a portion of the cool inlet air away from the APU compressor 120 and to the pyroelectric ERMs 126. Accordingly, an exposed surface of the pyroelectric ERMs 126 is cooled thereby causing a temperature change realized by the pyroelectric ERMs 126.

As mentioned above, a single temperature change realized by the pyroelectric ERMs 126 generates a temporary voltage. To maintain a continuous voltage output, the pyroelectric ERMs 126 must realize a continuous temperature change, i.e., the pyroelectric ERMs 126 must be heated and cooled in a continuous and alternating manner. Accordingly, the fast-acting valve 130 may be interposed between the air inlet 112 and the pyroelectric ERMs 126 to open and/or close the air delivery path to the pyroelectric ERMs 126. The fast-acting valve 130 may be controlled by, for example, a microprocessor. The continuous opening and closing of the valve 130 causes the cool inlet air to be modulated across the pyroelectric ERMs 126. The continuous modulation of cool air generates a continuous alternating temperature differential across the pyroelectric ERMs 126 to maintain a continuous output voltage. Accordingly, the inlet air that is provided to the APU compressor 120 may be leveraged and harnessed to generate additional energy that may be stored and/or utilized by one or more sub-systems of the aircraft.

Although cool inlet air is used as the coolant supplied to the pyroelectric ERMs 126, other coolants may be used. Referring to FIG. 2, for example, one end of one or more coolant lines 134 may be in fluid communication with an inlet 135 of a cooling unit 136 to receive a liquid coolant. The liquid coolant may include, but is not limited to, super-cooled water, propylene-glycol-water (PGW) mix, organic refrigerants, etc. The opposite end of the coolant line 134 may be disposed adjacent the pyroelectric ERMs 126 to deliver the cold liquid coolant thereto, thereby cooling a surface of the pyroelectric ERMs 126. A fast-acting valve 130 may be interposed between the cooling unit 136 and the pyroelectric ERMs 126 to modulate the coolant flowing to the pyroelectric ERMs 126 in each coolant line 134. In at least one embodiment, a fast-acting valve 130 may be interposed in one or more respective coolant lines 134, or in each of the coolant lines 134. The flow modulating valves 130 can be controlled and properly synchronized by a microprocessor. Accordingly, a temporary voltage is generated which may be output to the energy storage module 132 and stored therein. The energy storage module 132 may include, but is not limited to, a battery, a capacitor and a super-capacitor. In another embodiment, the voltage may also be output to one or more electrical sub-systems.

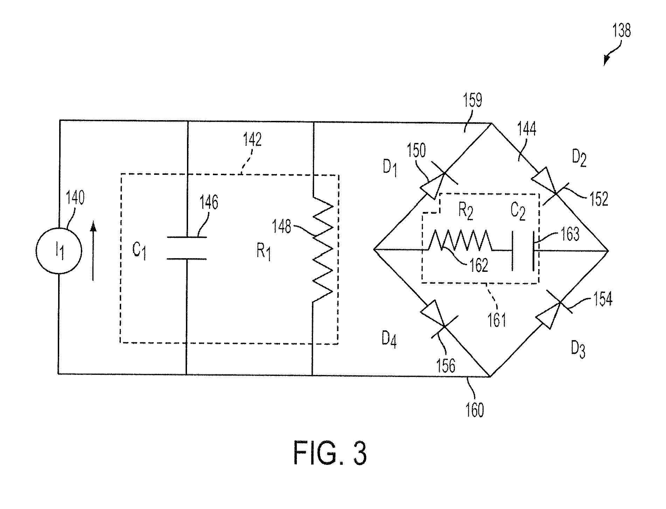

Turning to FIG. 3, an electrical schematic of a pyroelectric ERM circuit 138 is illustrated. The pyroelectric ERM circuit 138 includes a current source 140, a filter 142, and a bridge rectifier 144. The current source 140, the filter 142, and the bridge rectifier 144 are connected in parallel with each other. The filter 142 may comprise a first capacitor 146 and a first resistor 148. The first capacitor 146 is connected in a parallel with the current source 140 and the first resistor 148. The bridge rectifier 144 is connected across the output of the filter 142. The bridge rectifier 144 may comprise a first diode 150, a second diode 152, a third diode 154 and a fourth diode 156. Regarding the first and fourth diodes 150, 156, a cathode of the first diode 150 is connected to a first terminal 159 of the filter output and a cathode of the fourth diode 156 is connected to an opposing terminal 160 of the filter 142. The anode of the first diode 150 is connected to the anode of the fourth diode 156. Regarding the second and third diodes 152, 154, an anode of the second diode 152 is connected to the cathode of the first diode 150, and the anode of the third diode 154 is connected to the cathode of the fourth diode 156. In addition, the cathode of the second diode 152 is connected to the cathode of the third diode 154. In at least one embodiment, the bridge rectifier 144 may be formed as a Wheatstone bridge rectifier, which includes a current sensing circuit 161 connected between the anode of the first and fourth diodes 150, 156, and the cathode of the second and third diodes 152, 154. The sensing circuit 161 may include a second resistor 162 connected in series with a second capacitor 163.

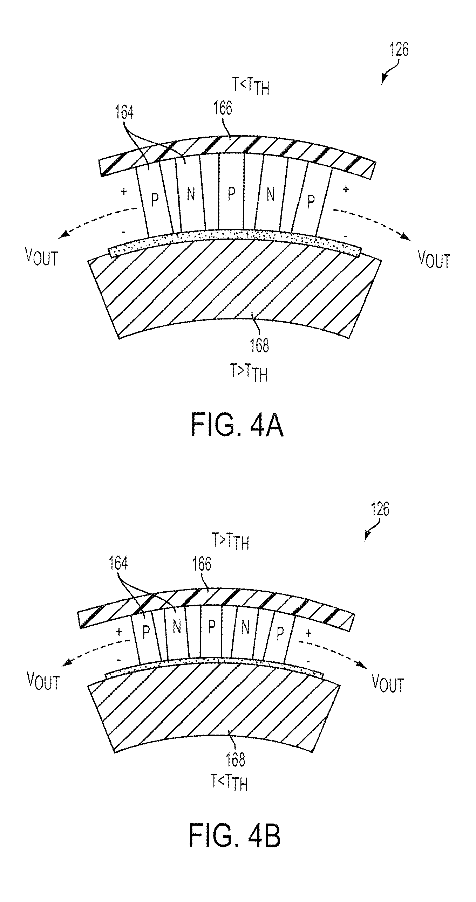

Referring now to FIGS. 4A and 4B, a pyroelectric ERM 126 is illustrated according to an embodiment. The pyroelectric ERM 126 includes a plurality of semiconductor elements 164 interposed between a first thermally conductive surface 166 and a second thermally conductive surface 168. The semiconductor elements 164 may be formed from a material including, but not limited to, gallium nitride (GaN), casesium nitride (CsNO₃), lithium tantalite, (LiTaO₃), and sintered ceramic comprising lead zirconite, lead tantalite, lead stanante, or a combination thereof. Various polymers including, but not limited to, Poly(Vinylidene Fluoride-TriFluoro-Ethylene) (P(VDF-TrFE)) may also be used to form the pyroelectric material.

The pyroelectric material of the ERM semiconductor element 164 is configured to generate voltage when the pyroelectric material is subjected to alternating heating and cooling. The heat absorbed by the pyroelectric material then changes the positions of the atoms in the material's crystal lattice structure. This leads to a polarization change which in turn, causes a voltage rise across the ERM semiconductor element. Typical energy densities for pyroelectric devices are quoted in the range of approximately 5 Watts per kilogram (W/kg) to approximately 30 W/kg) using, for example, Poly(Vinylidene Fluoride-TriFluoro-Ethylene (P(VDF-TrFE)). Accordingly, the pyroelectric ERM 164 regenerates energy that is typically "unused" or lost from the system. Thus, energy may be recaptured and regenerated without any large or complex rotating and/or moving parts.

The plurality of semiconductor elements 164 includes at least one P-type semiconductor element (P) and at least one N-type semiconductor element (N). The P-type element (P) is formed by doping a semiconductor element with a P-type material such as, for example, phosphorus (P). The N-type element N is formed by doping a semiconductor element with a N-type material such as, for example, boron (B). Further, the semiconductor elements 164 may have a temperature threshold (T_{TH}). In at least one embodiment, the ERM semiconductor elements 164 are formed as thin strips that may be formed against a heated surface, such as the APU exhaust duct 122. The strips may be thin enough such that they conform to the shape of the heated surface. Accordingly, a maximum surface area of the ERM may be disposed against the heat source to receive a maximum amount of heat, thereby maximizing the voltage generated by the pyroelectric ERM 126.

The first thermally conductive surface 166 may be cooled below (T_{TH}), while the second thermally conductive surface may be heated above (T_{TH}) 166 (See FIG. 4A). Accordingly, a temperature change is realized across the semiconductor elements 164. The temperature change generates a temporary voltage across the semiconductor elements 164, which may be output to an energy storage module 132 and/or an electrical system as discussed above. In order to maintain the output voltage (VOUT) at the pyroelectric ERM 126, the temperature realized by the first and second surfaces 166, 168 may be alternated. For example, the first thermally conductive surface 166 may be heated above (T_{TH}), while the second thermally conductive surface 168 may be cooled below (T_{TH}) (See FIG. 4B).

Based on the energy recovery and regeneration system 102 discussed above, a method of recovery and regenerating energy may be achieved. More specifically, a coolant may be provided to a first surface of the pyroelectric ERMs 126, which generate a voltage in response to realizing a temperature change as discussed above. The coolant may be modulated, for example by continuously opening and closing a fast-acting valve 130, such that the pyroelectric ERMs 126 realize a continuous temperature change, thereby generating a continuous voltage. The voltage output by the pyroelectric ERMs 126 may then be delivered to an energy storage module 132 to be stored, or to an electrical system to power one or more electronic devices.

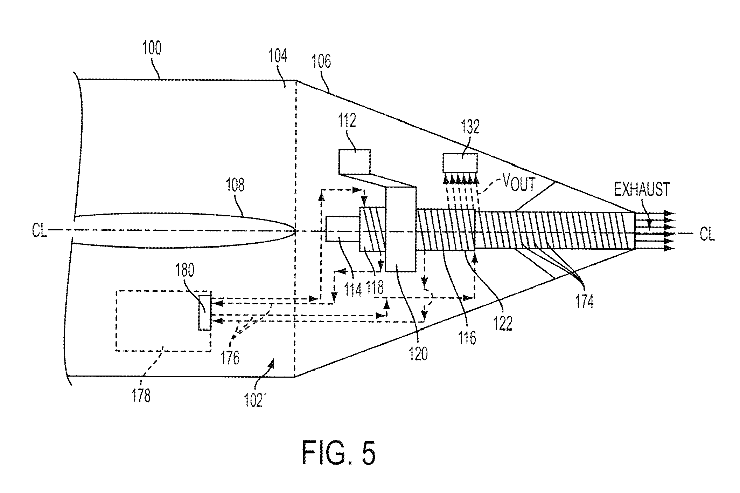

Turning now to FIG. 5, a top view of a rear portion of an aircraft bulkhead 100 including thermoelectric energy recovery and regeneration system 102' is illustrated. The thermoelectric energy recovery and regeneration system 102' includes one or more thermoelectric ERMs 174, one or more coolant supply lines 176, a supplemental cooling unit (SCU) 178, and an energy storage module 132. The thermoelectric ERMs 174 generate a voltage in response to realizing a temperature differential thereacross.

Unlike the pyroelectric ERMs 126, a continuous alternating temperature change is not necessary to maintain an output voltage. The coolant lines 176 include a first end that is in fluid communication with an inlet 180 of the SCU 178. The coolant lines 176 may then be formed adjacent a thermally conductive surface of the thermoelectric ERMs 174 to deliver cooler temperature to thereto. The opposite surface of the thermoelectric ERMs 174 may be heated. For example, the opposite surface of the thermoelectric ERMs 174 may be disposed against the heated exterior surface of the APU exhaust duct 122. Accordingly, the thermoelectric ERMs 174 realize a temperature change, thereby generating an output voltage (V_{OUT}) that may be stored by an energy storage module 132 as discussed above. The coolant lines 176 may be returned to the SCU 178, which re-cools the coolant and returns cooled coolant back to the thermoelectric ERMs 174 to maintain the temperature difference. Although coolant lines 176 and an SCU 178 is described with respect to the thermoelectric energy recovery and regeneration system 102', it is appreciated that the bleed air line 124 and valve 130 as discussed above may be used to provide cool air to the thermoelectric ERMs 174, and vice versa. It is also appreciated that combination of the SCU 178, the coolant lines, the bleed air line 124 and the valve 130 may also be used.

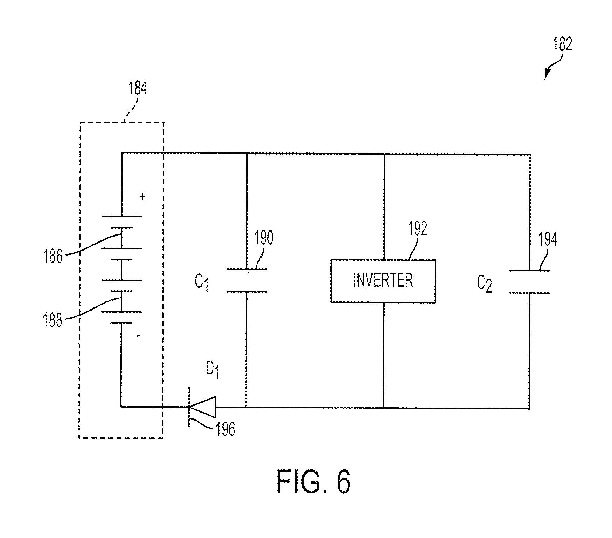

Referring now to FIG. 6, an electrical schematic of a thermoelectric ERM circuit 182 is illustrated. The thermoelectric ERM circuit 182 includes a dual voltage source 184 including first and second voltages sources 186, 188 connected in series, a first capacitor 190, an inverter 192 and a second capacitor 194, all of which are connected in parallel with each other. The inverter 192 is interposed between the first capacitor 190 and the second capacitor 194. The thermoelectric ERM circuit 182 may further include a diode 196 having a cathode connected to a negative terminal of the dual voltage source 184 and an anode commonly connected to an end of the first capacitor 190, the inverter 192 and the second capacitor 194.

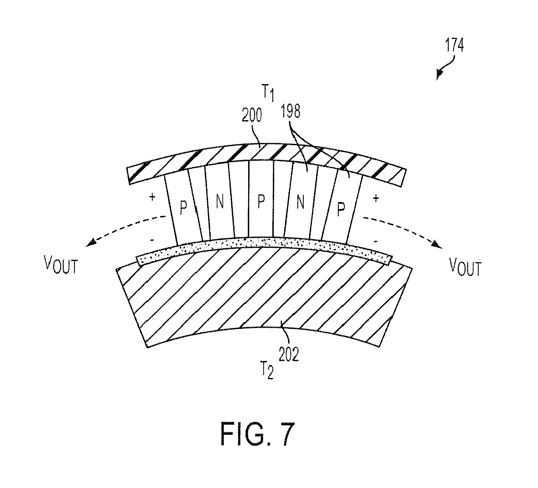

Turning to FIG. 7, a thermoelectric ERM 174 included in a thermoelectric energy recovery and regeneration system 102' is illustrated. The thermoelectric ERM 174 includes a plurality of semiconductor elements 198 interposed between a first thermally conductive surface 200 and a second thermally conductive surface 202. The plurality of semiconductor elements 198 includes at least one P-type semiconductor element (P) and at least one N-type semiconductor element (N). The P-type element (P) is formed by doping a semiconductor element with a P-type material such as, for example, phosphorus (P). The N-type element (N) is formed by doping a semiconductor element with a N-type material such as, for example, boron (B). The first thermally conductive surface 200 may be heated to a first temperature (T₁), while the second thermally conductive surface 202 may be cooled (T₂). Accordingly, a temperature differential (T₂-T₁) is generated across the semiconductor elements 198, which induces a voltage across the semiconductor elements 164. The output voltage (V_{OUT}) may be delivered to an energy storage module 132 and/or an electrical system as discussed above.

Based on another embodiment of an energy recovery and regeneration system 102 discussed above, a method of recovery and regenerating energy may be achieved. More specifically, a first thermally conductive surface 200 of the thermoelectric ERMs 174 is heated while a second thermally conductive surface 202 of the thermoelectric ERMs is cooled. Accordingly, a temperature differential between the first and second surfaces 200, 202 is generated, which causes thermoelectric ERMs 174 to generate a voltage as discussed above. The voltage output (V_{OUT}) by the thermoelectric ERMs 174 may then be delivered to an energy storage module 132 to be stored, or to an electrical system to power one or more electronic devices.

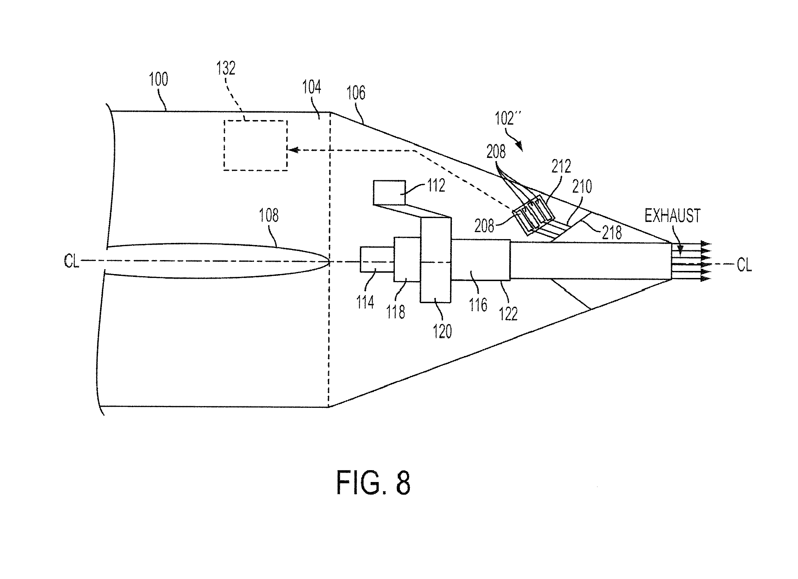

Turning now to FIG. 8, a top view of a rear portion of an aircraft bulkhead 100 including an piezoelectric energy recovery and regeneration system 102" is illustrated. The piezoelectric energy recovery and regeneration system 102" includes one or more piezoelectric ERMs 208, a coupling member 210 formed at a respective piezoelectric ERM 208 to deliver vibration thereto, and an energy storage module 132. A flexible base 212 may be provided to support one or more of the piezoelectric ERMs 208. The piezoelectric ERMs 208 generate a voltage in response to realizing a vibration. In at least one example, one end of a coupling member 210 is connected to a respective piezoelectric ERM 208 and an opposite end of the coupling member 210 is connected to a source of vibration. For example, the bulkhead 100 itself, or various portions of the bulkhead 100, such as one or more exhaust support struts 218 which support the APU exhaust duct 122, typically vibrate during flight. The coupling members 210, therefore, deliver vibrations to the piezoelectric ERMs 208 to generate an output voltage. Accordingly, vibrations of the aircraft, e.g., vibrations of the bulkhead 100 caused when the rudder of the tail fin assembly 108 and/or horizontal stabilizers (not shown) is adjusted, may be harnessed and utilized to generate voltage that may be stored and/or utilized by one or more electrical subsystems.

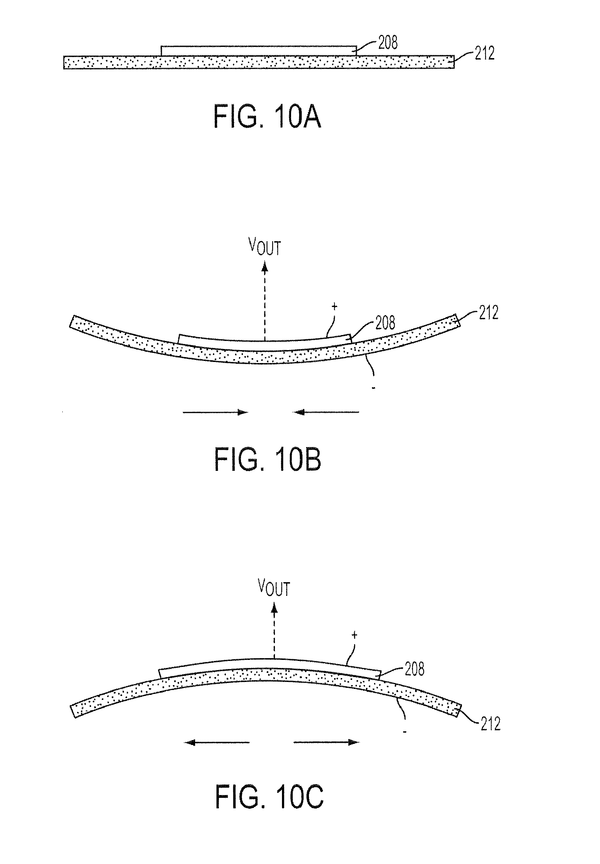

In another embodiment, a first linking end of a first coupling member 210 is formed at a first end of the piezoelectric ERM 208, while a first linking end of a second coupling member 210 is formed at an opposite end of the piezoelectric ERM 208. The second linking ends of the first and second coupling members may be formed against a vibration source, such as the exhaust struts 218 for example. As the struts 218 vibrate, the first and second coupling members 210 are forced toward and/or away from each other. The piezoelectric ERM 208 therefore realizes a vibration that that deforms (i.e., pushes or pulls) the piezoelectric material thereby generating the output voltage (see FIGS. 10B-10C).

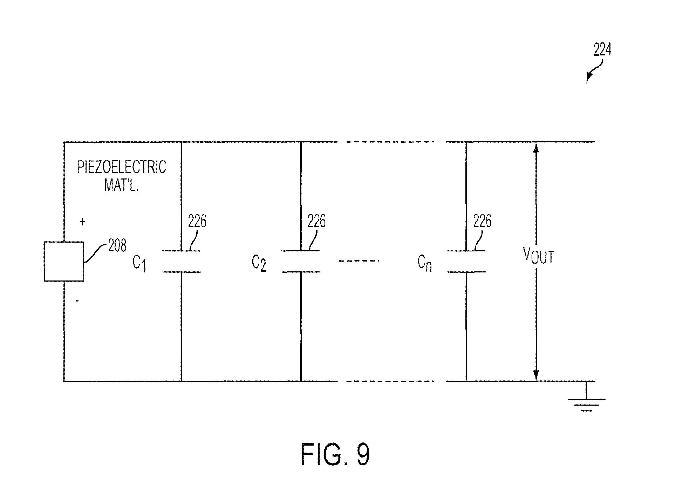

Referring to FIG. 9, an electrical schematic of a piezoelectric ERM circuit 224 is illustrated. The piezoelectric ERM circuit 224 comprises a piezoelectric element 208 connected in parallel with a piezoelectric capacitor 226 and one or more output capacitors 226. The piezoelectric element 228 may be formed from a piezoelectric material including, but not limited to, quartz, topaz and tourmaline. Accordingly, a voltage, V_{OUT}, may be generated across the one or more output capacitors 226 in response to vibrating and/or deforming the piezoelectric element 228. The voltage across the output capacitors 228 may be output to an energy storage module and/or utilized by one or more electrical sub-systems.

Turning to FIGS. 10A-10C, operation of a piezoelectric ERM 208 included in a piezoelectric energy recovery and regeneration system 102" is illustrated. More specifically, when the piezoelectric ERM 208, attached to a flexible base 212, is not vibrated or deformed, the piezoelectric ERM remains in a steady-state and does not generate a voltage (see FIG. 10A). When the piezoelectric ERM 208 is vibrated and/or deformed, however, the piezoelectric ERM 208 generates a voltage thereacross. For example, the piezoelectric ERM 208 generates a voltage when the piezoelectric ERM is forced inward thereby deforming in a first direction (see FIG. 10B) and/or when the piezoelectric ERM is forced outward thereby deforming in a second direction (see FIG. 10C). The output voltage (V_{OUT}) generated by the piezoelectric ERM 208 is proportional to the amount of physical force or mechanical displacement (stress) applied to the piezoelectric ERM material. Accordingly, larger vibrations of the aircraft generate a larger output voltage from the piezoelectric ERM 208.

Therefore, based on yet another embodiment of an energy recovery and regeneration system 102 as discussed above, a method of recovery and regenerating energy may be achieved. More specifically, a vibration may be delivered to the piezoelectric ERM 208. The vibration may be applied to the piezoelectric ERM, 208 or may be applied to ends of the piezoelectric ERM 208 to deform the piezoelectric material. In response to realizing the vibration and/or deformation, the piezoelectric ERMs 208 generate a voltage as discussed above. The voltage output (V_{OUT}) generated by the piezoelectric ERMs 208 may then be delivered to an energy storage module 132 to be stored, or to an electrical system to power one or more electronic devices.

Accordingly, at least one embodiment described in detail above provides an energy recovery and regeneration system configured to harness/recover energy existing at the aircraft, and convert the energy without any large rotational and/or complex moving parts. The energy recovery and regeneration system includes a ERM that is configured to harness/recapture energy lost by one or more systems of an aircraft, and regenerate the energy which may be stored in an energy storage module and/or used to power one or more electrical sub-systems without the use of large and/or complex moving parts.

While the invention has been described with reference to an exemplary embodiment or embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the claims.

## Claims

1. An energy recovery and regeneration system, comprising:
at least one pyroelectric energy recovery module (ERM) (126) that generates a voltage in response to realizing a temperature change;
a coolant line (128) including a first end in fluid communication with a coolant source to receive a coolant and a second end disposed adjacent the at least one pyroelectric ERM (126) to deliver the coolant thereto;
a valve (130) interposed between the coolant source and the at least one pyroelectric ERM (126), the value (130) configured to modulate the coolant delivered to the at least one pyroelectric ERM (126) to generate the temperate change; and
an energy storage module (132) in electrical communication with the pyroelectric ERM (126), the energy storage module (132) configured to store the voltage generated by the at least one pyroelectric ERM (126).

2. The energy recovery and regeneration system of claim 1, wherein the pyroelectric ERM (126) includes a first surface to receive the coolant and a second surface to receive heat.

3. The energy recovery and regeneration system of claim 2, wherein the first end of the coolant line (128) is in fluid communication with an air inlet (135) to receive cool air and the second end delivers the cool air to the first surface.

4. The energy recovery and regeneration system of claim 3, wherein the valve (130) is controlled to continuously open and close to modulate the cool inlet air.

5. The energy recover system of any of claims 2-4, wherein the pyroelectric ERM (126) is formed from a thin pyroelectric material configured such that the second surface conforms to a heat source that generates the heat.

6. An energy recovery and regeneration system, comprising:
at least one thermoelectric energy recovery module (ERM) (174) including a first surface and a second surface, the thermoelectric ERM (174) configured to generate a voltage in response to realizing a temperature differential between the first surface and the second surface;
at least one coolant line (176) including a first end in fluid communication with a coolant source (178) to receive a coolant and a second end disposed adjacent the second surface of the at least one thermoelectric ERM (174) to deliver the coolant thereto such that the second surface has a temperature less than the first surface; and
an electronic device in electrical communication with the at least one thermoelectric ERM (174), the electronic device configured to operate in response to the voltage generated by the thermoelectric ERM (174).

7. The energy recovery and regeneration system of claim 6, further comprising a cooling unit (178) that generates a cool liquid, wherein the first end of the at least one coolant line (176) is in fluid communication with the cooling unit (178) to receive the cool liquid, and the second end delivers the cool liquid adjacent the at least one thermoelectric ERM (174) to cool the second surface.

8. The energy recovery and regeneration system of claim 6 or 7, wherein the first surface of the thermoelectric ERM (174) is formed against a heat source.

9. The energy recovery and regeneration system of claim 8, wherein the thermoelectric ERM (174) is formed from a thin thermoelectric material configured such that the second surface conforms to a shape of the heat source.
